# EUROPÄISCHE PATENTSCHRIFT

(11) **EP 1 888 293 B1**
(45) Veröffentlichungstag und Bekanntmachung des Hinweises auf die Patenterteilung: **20.08.2008**
(21) Anmeldenummer: 06723977.2
(22) Anmeldetag: 03.04.2006
(51) Int. Cl.: B23K 26/42, G01K 11/00, G01K 17/00, H01L 27/146

(54) **OPTISCHES ELEMENT SOWIE VERFAHREN ZUR ERFASSUNG VON STRAHLPARAMETERN, MIT EINEM ALS PIXELS-MATRIX AUSGEBILDETEN TEMPERATURSENSOR**
OPTICAL ELEMENT AND METHOD FOR RECORDING BEAM PARAMETERS, COMPRISING A TEMPERATURE SENSOR PROVIDED IN THE FORM OF A PIXEL MATRIX
ELEMENT OPTIQUE ET PROCEDE POUR COLLECTER DES PARAMETRES DE FAISCEAU AVEC UN CAPTEUR DE TEMPERATURE REALISE SOUS FORME DE MATRICE DE PIXELS

(30) Priorität: 01.04.2005 EP 05007148
(43) Veröffentlichungstag der Anmeldung: 20.02.2008
(73) Patentinhaber: TRUMPF Werkzeugmaschinen GmbH + Co. KG, 71254 Ditzingen (DE)
(72) Erfinder: WEICK, Jürgen-Michael, 71679 Asperg (DE); HORN, Armin, 71272 Renningen (DE); HAMMANN, Gerhard, 70825 Korntal-Münchingen (DE); LAITENBERGER, Peter, CB4 1 AG Cambridge (GB); COLLIER, Nick, CB5 0AA Burwell (GB); JONES, Ross, Peter, Cambridge CB1 8QH (GB)
(74) Vertreter: Maser, Jochen
(86) Internationale Anmeldenummer: PCT/EP2006/003019
(87) Internationale Veröffentlichungsnummer: WO 2006/103104

(56) Entgegenhaltungen:
- WO-A-99/39394
- US-A- 6 031 248
- US-A1- 2002 021 450
- US-A1- 2002 110 180
- US-A1- 2003 090 256
- PROMETEC GMBH: "In-Process-Messung und UEBERWACHUNG VON UNFOKUSSIERTER LASERSTRAHLUNG-Laser scope UFC 60" INTERNET, 11. Januar 2001 (2001-01-11), XP002197030

## Beschreibung

Die Erfindung betrifft ein optisches Element zum Führen und Formen eines Laserstrahles gemäß dem Oberbegriff des Anspruchs 1 sowie ein Verfahren zur Erfassung von Strahlparametern mit einem solchen optischen Element gemäß dem Oberbegriff des Anspruchs 13 (siehe, z.B., US 2003/090256 A1).

In der industriellen Fertigung ist der Einsatz von Laserstrahlen zur Bearbeitung von Materialien weit verbreitet. Zur Überwachung der Bearbeitung und zur Qualitätssicherung ist erforderlich, dass eine gleichbleibende Leistung einer elektromagnetischen Strahlung durch eine Laseranordnung erzeugt und mit gleichbleibenden Parametern ausgegeben wird. In einer Laseranordnung sind mehrere optische Elemente vorgesehen, durch die der Strahl geführt und geformt wird. Gleichzeitig wird dadurch auch die Leistung des Strahles beeinflusst. Die Qualität der Laseranordnung wird im Wesentlichen durch die Strahlausrichtung, die Strahlprofilierung und die Strahlleistung bestimmt. Diese Parameter sind für die Bearbeitungsprozesse zu optimieren und können durch Alterung, beginnende Zerstörung und/oder Verschmutzung der optischen Elemente nachteilig beeinflusst werden. Solche Einflüsse wirken sich wiederum auf die Strahlparameter der elektromagnetischen Strahlung beziehungsweise des Laserstrahles nachteilig aus. Um diese Parameter zu erfassen oder zu überwachen, besteht die Möglichkeit, dass ein sogenannter Mode-Schuss eines Laserstrahls gefertigt wird. Der durch die Laseranordnung erzeugte Laserstrahl wird aus dem üblichen Strahlengang ausgekoppelt und auf einen Plexiglaswürfel gerichtet, wodurch beim Auftreffen des Laserstrahles Material verdampft und die verbleibende Kontur eine Aussage über die Qualität des Strahles ermöglicht. Diese Technik ist zeitaufwändig und erfordert eine Unterbrechung der Produktion.

Aus einem Prospekt der Firma Prömetec mit dem Titel "Laserscope UFC60" ist eine Vorrichtung bekannt, durch welche eine kontinuierliche Vermessung und Überwachung unfokussierter Laserstrahlung von Lasern mit hoher Leistung, welche vornehmlich in der Laserbearbeitung eingesetzt wird, ermöglicht ist. Die Vorrichtung arbeitet nach dem Messprinzip, wonach ein Draht seinen elektrischen Widerstand erhöht, wenn sich seine Temperatur aufgrund absorbierter Strahlung erhöht. Zur Ermittlung von Messdaten sind mehrere übereinander angeordnete Gitter mit extrem dünnen, nebeneinander angeordneten Drähten vorgesehen. Zur Strahlüberwachung wird ein Gerät mit zwei übereinander gelagerten Gittern vorgeschlagen, wobei diese die Gitter aufnehmende Vorrichtung derart in einem Strahlweg zu positionieren ist, dass der Laserstrahl diese Gitter durchläuft.

Diese Vorrichtung ist aufgrund einem die Gitter aufnehmenden Gehäuse nicht im laufenden Betrieb einer Laseranordnung möglich. Dadurch können keine Online-Messungen durchgeführt werden. Des Weiteren sind die zur Erfassung von Informationen vorgesehenen Drähte äußerst empfindlich, da sie einen Durchmesser im unteren Mikrometerbereich aufweisen und sehr leicht brechen können. Insbesondere ist eine Kühlung der Gitter für eine exakte Messung schwer möglich, da die Drähte bei einer starken Luftströmung noch leichter brechen. Ohne Kühlung der Gitter sind die erfassten Werte jedoch durch kontinuierliches Aufheizen der Gitter mit Fehlern behaftet. Des Weiteren können sich Schmutzpartikel an dem Gitter anlagern und die Messergebnisse zusätzlich verfälschen. Darüber hinaus ist die Vorrichtung nicht innerhalb einem Lasergerät, einer Strahlquelle oder einem Strahlerzeuger einsetzbar. Auch kann die Verschmutzung, Alterung und Beginn der Zerstörung von optischen Elementen nicht erfasst werden.

Aus der FR 2 698 495 A1 geht ein Verfahren zur Messung einer Temperatur von einer Linse hervor, die in einer Laseranordnung vorgesehen ist. Zur Erfassung der Temperatur der Linse ist ein erstes Thermoelement vorgesehen, das am Rand der Linse angebracht ist. Ein weiteres Temperaturelement ist auf einer Vorderseite eines Ausgangs der Linse außerhalb des Strahlenganges angeordnet. Ein drittes Thermoelement ist an einer Schulter der Aufnahme angebracht. Diese drei Thermoelemente sind jeweils um 120° zueinander versetzt angeordnet und leiten die erfasste Temperatur an eine Auswerteeinheit weiter. Sobald die erfasste Temperatur einen Schwellwert überschritten hat, wird ein Alarmsignal ausgegeben.

Durch die Anordnung der Thermoelemente auf der Linse und der Linsenaufnahme werden Einzelmessungen an den jeweiligen Kontaktstellen der Thermoelemente zur Linse durch die Thermoelemente durchgeführt. Daraus ist eine Aussage über die Bestimmung des Verschmutzungsgrades oder einer beginnenden Zerstörung oder Alterung als auch der Leistung des Strahles oder weiterer Strahlparameter nicht ermöglicht.

Aus der US-PS 4,692,623 ist eine Vorrichtung bekannt, die zur Erfassung einer Lage und einer Position eines Laserstrahles vorgesehen ist. Diese Vorrichtung weist auf einem Glassubstrat ein Gitter von Leiterbahnen auf, wobei die Leiterbahnen in den Kreuzungspunkten zueinander isoliert sind. Diese Leiterbahnen können mit einer reflektierenden Beschichtung abgedeckt sein. Ein Detektor und eine Anzeigevorrichtung zur Erfassung der Änderung des elektrischen Widerstandes aufgrund der absorbierten Wärme sind mit den Leiterbahnen verbunden.

Eine analoge Anordnung ist aus der CH 690 796 A5 bekannt. Der in dieser Druckschrift offenbarte Spiegel unterscheidet sich von der vorhergehenden Vorrichtung dadurch, dass das Gitter der Leiterbahnen in zwei Ebenen durch eine Isolierung getrennt ausgebildet ist. Auf einer Isolierung auf dem Trägermaterial des Spiegels ist eine erste Lage aus einer Vielzahl von parallel zueinander angeordneten Leiterbahnen vorgesehen. Diese Lage ist mit einer Isolierung abgedeckt, welche wiederum eine zweite Lage von parallel zueinander laufenden Leiterbahnen aufnimmt. Die zweite Lage der Leiterbahnen ist um 90° zur ersten Lage gedrehet ausgerichtet. Auch die zweite Lage der Leiterbahnen ist durch eine Isolierung abgedeckt. Jeweils an den äußeren Enden der Leiterbahnen sind Kontaktflächen zum Anschließen an eine Auswerteeinheit vorgesehen.

Aus der EP 1 310 782 A1 ist ein optisches Element bekannt geworden, welches auf einem Trägermaterial eine Beschichtung aufweist. Solche optischen Elemente werden zum Führen und Formen eines Laserstrahles eingesetzt. Zur Erfassung einer Lage und einer Position eines Laserstrahles ist vorgesehen, dass das optische Element eine Gitterstruktur aus dünnem, leitfähigen Material auf oder in der Beschichtung oder dem Trägermaterial aufweist. Über Kontaktelemente, die an dem optischen Element angreifen, können die erfassten Messwerte in eine Messeinrichtung oder Auswerteeinheit weitergeleitet werden.

Die drei vorgenannten Vorrichtungen gemäß der US-PS 4,692,623, CH 690 796 A5 und EP 1 310 782 A1 haben alle gemeinsam, dass in den Trägermaterialien aufgrund der absorbierten Strahlung eine Temperaturänderung bewirkt wird, die wiederum auf die Leiterbahnen übertragen wird, um eine Änderung des elektrischen Widerstandes in den Leiterbahnen zu erfassen. Diese Temperaturänderung kann jedoch nur integral über die jeweilige Leiterbahn, bzw. deren Länge zwischen beiden Endpunkten, erfasst werden. Dadurch kann eine Auswertung zur Strahllage und Strahlgröße nur annähernd erfolgen. Eine Auswertung einer Intensitätsverteilung des Strahls, wie sie durch einen Mode-Schuss sichtbar gemacht wird, ist nicht möglich.

Der Erfindung liegt deshalb die Aufgabe zugrunde, ein optisches Element zum Führen und Formen eines Laserstrahles vorzuschlagen, das eine präzise Erfassung der Strahllage, des Strahldurchmessers und der Intensitätsverteilung des Strahles unter Beibehaltung der Strahlführungseigenschaften eines elektromagnetischen Strahles ermöglicht.

Diese Aufgabe wird erfindungsgemäß durch ein optisches Element zum Führen und Formen eines Laserstrahles gemäß den Merkmalen des Anspruchs 1 gelöst.

Das erfindungsgemäß ausgebildete optische Element weist den Vorteil auf, dass eine exakte Auswertung der Strahlparameter, wie beispielsweise die Strahllage, der Strahldurchmesser und die Intensitätsverteilung des Strahles ermöglicht ist. Durch die Ausgestaltung des Temperatursensors als Matrix aus einer Vielzahl von Pixeln ist eine Ortsauflösung der Intensität für den auf das optische Element auftreffenden Laserstrahles ermöglicht. Aufgrund einer solchen Ortsauflösung der Intensität kann eine Strahlveränderung während des Betriebes einer Laseranlage ohne Auskoppelung des Laserstrahles erfasst werden. Die Strahlveränderung stellt ein Abbild über den Zustand des Lasers dar, so dass nicht nur optische Elemente, sondern auch weitere Komponenten der Laseranlagen überwacht werden können. Durch die erfindungsgemäße Ausgestaltung des optischen Elementes kann der sogenannte Mode-Schuss ersetzt werden. Ein Auskoppeln des Laserstrahles zur Erzeugung eines Mode-Schusses ist nicht mehr erforderlich. Die durch den Temperatursensor erfassten Messwerte ermöglichen des Weiteren eine Auswertung einer thermischen Belastung des optischen Elementes sowie über den Zustand des optischen Elementes bzgl. der Alterung und Verschmutzung oder beginnenden Zerstörung. Gleichzeitig kann durch den Einsatz von zumindest einem erfindungsgemäßen optischen Element eine permanente Überwachung der Laseranlage ohne einen Eingriff in die laufende Fertigung gegeben sein.

Nach einer vorteilhaften Ausgestaltung der Erfindung ist vorgesehen, dass das optische Element als Trägermaterial eine Matrix aus temperatursensitiven Elementen umfasst. Durch die Anordnung der temperatursensitiven Elemente in einer Matrix als Temperatursensor kann gleichzeitig eine Aussage über weitere Strahlparameter, wie beispielsweise die Lage der Auftrefffläche und die Größe beziehungsweise den Durchmesser des elektromagnetischen Strahles, die lokale Auflösung der Intensitätsverteilung, die absolute Strahlleistung, das zeitliche Auflösevermögen, erfolgen. Durch die Erfassung der Lage können die Strahlausrichtung beziehungsweise der Strahlverlauf zum optischen Element und folglich gegebenenfalls vorliegende Dejustierungeri erfasst werden. Durch die Erfassung des Strahldurchmessers und/oder des Temperaturprofils kann die aktuelle Leistung im Vergleich zur bekannten Sollleistung des Strahles ermittelt werden.

Nach einer weiteren vorteilhaften Ausgestaltung des Verfahrens ist vorgesehen, dass das zumindest eine temperatursensitive Element in einem Siliziumwafer, insbesondere als Diode, aufgebaut ist. Bei der Verwendung des Halbleitermaterials als Trägersubstrat können insbesondere die Dioden als temperatursensitive Elemente unmittelbar in das Trägersubstrat implementiert werden. Bevorzugt werden CMOS-Prozesse verwendet, um die Dioden herzustellen. Weitere bekannte Herstellungsprozesse können ebenfalls verwendet werden.

Die temperatursensitiven Elemente sind bevorzugt in sogenannten P-oder N-dotierten Vertiefungen oder Wannen ("p-wells" oder "n-wells") eingebettet. Dadurch ist eine elektrische Isolation zwischen den einzelnen Dioden gegeben, wodurch ein Übersprechen zwischen den verschiedenen temperatursensitiven Elementen vermindert oder verhindert ist.

Bevorzugt sind die temperatursensitiven Elemente thermisch zueinander isoliert. Hierfür werden beispielsweise Gräben im Trägersubstrat, insbesondere Siliziumwafer, vorgesehen, um diese temperatursensitiven Elemente voneinander zu isolieren. Diese Gräben sind mit einer Isolierschicht gefüllt und werden als "deep-trench isolation" bezeichnet. Dadurch kann die Erfassung und Lokalisierung des auf dem optischen Element auftreffenden elektromagnetischen Strahles exakt lokalisiert werden. Gleichzeitig kann dadurch für jedes temperatursensitive Element eine verbesserte Temperaturerfassung ermöglicht werden, wodurch die Strahlprofilierung präziser erfassbar ist.

In einer bevorzugten Ausführungsform sind in einem Pixel mehrere temperatursensitiven Elemente in Reihe geschalten. Dadurch können ein oder mehrere zeitabhängige Merkmale oder Kennlinien innerhalb der Sensorkette gemessen werden, wie beispielsweise einen Spannungsabfall bei einem bestimmten Strom oder ein bestimmter Stromabfall bei einer bekannten Spannung. Dadurch, dass vorteilhafterweise ein Pixel der Matrix mehrere temperatursensitive Elemente umfasst, kann die Messgenauigkeit eines Pixels und somit die Leistungsfähigkeit des aus mehreren Pixel bestehenden Temperatursensors erhöht werden. Alternativ kann vorgesehen sein, dass die temperatursensitiven Elemente eines Pixels parallel geschalten sind, wodurch ebenfalls eine gemittelte Aussage über eine Temperatur des Pixels ermöglicht ist.

Eine bevorzugte Ausführungsform sieht vor, dass an einer dem Temperatursensor zugewandten Seite des Trägersubstrates eine Beschichtung und an einer dem Temperatursensor abgewandten Seite des Trägersubstrats ein Trägermaterial vorgesehen ist. Dieser Aufbau ermöglicht, dass insbesondere sehr dünne Siliziumwafer für das Implementieren der Dioden zur Herstellung der Pixel als Matrix zur Ausbildung eines Temperatursensors einsetzbar sind. Darüber hinaus können eine Vielzahl von Trägermaterialien angesetzt werden, die eine hohe thermische Leitfähigkeit und/oder mechanische Steifigkeit aufweisen, um das Trägersubstrat aufzunehmen. Beispielsweise kann eine Klebeverbindung zwischen dem Trägersubstrat und dem Trägermaterial vorgesehen sein. Solche Trägermaterialien können aus Metall, insbesondere Kupfer als auch anderen Materialien wie bspw. Silizium vorgesehen sein.

Eine alternative Ausführungsform des optischen Elementes sieht vor, dass an einer dem Temperatursensor abgewandten Seite des Trägersubstrates ein Trägermaterial vorgesehen ist und an der gegenüberliegenden Seite des Trägermaterials eine Beschichtung aufgebracht ist. Dieser Aufbau ermöglicht bspw., dass in Abhängigkeit des Trägermaterials eine erhöhte Reflektion bzw. eine verringerte Transmission des Laserstrahles gegeben ist, so dass das Trägermaterial als Filter wirkt, wobei noch eine hinreichende Strahlungsenergie auf den Temperatursensor einwirkt.

Zwischen einer Beschichtung und dem Trägersubstrat ist bevorzugt eine Passivierungsschicht vorgesehen, um die hochreflektierende Beschichtung von den Anschlüssen des Temperatursensors sowie den temperatursensitiven Elementen zu trennen. Diese Anordnung ist bei einer ersten Ausführungsform eines Schichtaufbaus für das optische Element vorgesehen. Bei der zweiten alternativen Ausführungsform ist der Temperatursensor im Strahlengang zum einfallenden Laserstrahl abgewandt zugeordnet und nimmt auf seiner Rückseite bevorzugt eine Absorberschicht auf.

Nach einer weiteren vorteilhaften Ausgestaltung der Erfindung ist vorgesehen, dass auf einer der Beschichtung gegenüberliegenden Rückseite des Trägermaterials eine spannungskompensierende Schicht aufgebracht ist, die vorzugsweise aus einem Siliziumnitrid oder ähnlichen Materialien besteht. Eine solche Schicht kann beispielsweise durch plasmaunterstützte oder chemische Aufdampfungsverfahren aufgebracht werden.

Gemäß der Erfindung ist vorgesehen, dass die Beschichtung des optischen Elementes einen Reflektionsgrad der Laserstrahlung von wenigstens 98 % aufweist. Dadurch bleiben einerseits die Abbildungseigenschaften, insbesondere das Führen und/oder Formen des Laserstrahls, erhalten, und andererseits wird der Temperatursensor vor der Intensität des eintreffenden Laserstrahls geschützt. Die Beschichtung führt dazu, dass der Laserstrahl abgeschwächt auf den Temperatursensor einwirkt und somit eine Filterfunktion hat. Die nicht reflektierte Strahlung beziehungsweise deren Abwärme wird für die Messung verwendet.

Des Weiteren ist bevorzugt vorgesehen, dass zumindest ein Multiplexer und vorzugsweise elektronische Bauteile für den Temperatursensor benachbart zu der aus Pixel bestehenden Matrix in dem Trägersubstrat aufgebaut bzw. eingebettet sind. Dadurch kann eine vollständig integrierte Ausgestaltung eines Temperatursensors geschaffen werden, bei dem sowohl die temperatursensitiven Elemente als auch die zugehörige Schaltung und Signalumwandlung in dem optischen Element erfolgt, so dass eine einfache Ausgabe eines Signals ermöglicht ist.

Die erfindungsgemäße Aufgabe wird des Weiteren durch ein Verfahren zur Erfassung von Strahlparametern gelöst, bei dem ein oder mehrere optische Elemente gemäß einer der vorhergehenden vorteilhaften Ausführungsformen in einem Strahlengang eines elektromagnetischen Strahles abgefragt und die erfassten Signale in einer Auswerteeinheit erfasst werden (siehe Anspruch 13). In der Auswerteeinheit werden die Daten der einzelnen Pixel aufgenommen und ausgewertet, so dass eine exakte Ermittlung der Strahllage, des Strahldurchmessers als auch der Intensitätserteilung ermöglicht ist. Bereits mit einem einzigen in dem Strahlengang angeordneten erfindungsgemäßen optischen Element können die zur Überwachung wichtigen Informationen wie die Strahllage, der Strahldurchmesser und die Intensitätserteilung des Strahles erfasst werden. Bei einer über eine längere Zeitdauer durchgeführten Überwachung kann gleichzeitig eine Veränderung der Strahlparameter durch einen Vergleich innerhalb verschiedener Zeitintervalle erfolgen. Sofern mehrere optische Elemente in einem Strahlengang einer Laseranlage vorgesehen sind, können die erfassten Strahlparameter an jedem einzelnen optischen Element miteinander verglichen werden, wodurch beispielsweise eine Veränderung des Strahlprofils entlang des Strahlenganges sowie eine Veränderung der Strahllage und ein Abfall einer Strahlleistung erfassbar sind. Dadurch können gleichzeitig auch Rückschlüsse über eine beginnende Zerstörung, Alterung und Verschmutzung des oder der optischen Elemente ermittelt werden. Zusätzlich kann durch die Auswerteeinheit ein selbständiges Nachregeln von Parametern in der Laseranordnung ermöglicht werden, um die Strahlparameter zu optimieren.

Vorteilhafterweise ist vorgesehen, dass die durch die optischen Elemente erfassten Daten von der Auswerteeinheit über eine Datenfernübertragungseinheit zur Fernabfrage bereitgestellt werden. Dadurch ist eine Ferndiagnose beziehungsweise ein Teleservice als auch eine Fernwartung ermöglicht. Vorteilhafterweise ist vorgesehen, dass in einer zentralen Erfassungsstelle mehrere Laseranlagen überwacht werden. Bei Abweichungen der Sollwerte, welche für den optimalen Betrieb bestimmt sind, kann von der Erfassungsstelle, die räumlich getrennt zu den Laseranlagen eingerichtet ist, auf die jeweilige Laseranlage zugegriffen werden, um die Laseranlage auf die optimalen Parameter einzustellen.

Die Erfindung sowie weitere vorteilhafte Ausführungsformen und Weiterbildungen derselben werden im Folgenden anhand den in den Zeichnungen dargestellten Beispielen näher beschrieben und erläutert. Die der Beschreibung und den Zeichnungen zu entnehmenden Merkmale können einzeln für sich oder zu mehreren in beliebiger Kombination erfindungsgemäß angewandt werden. Es zeigen:
- Figur 1: einen schematischen Aufbau einer Laserbearbeitungsmaschine,
- Figur 2: eine perspektivische Ansicht eines erfindungsgemäßen optischen Elementes,
- Figur 3: eine schematische Draufsicht auf einen in einem optischen Element vorgesehenen Temperatursensor ohne Beschichtung,
- Figur 4: eine schematische Schnittdarstellung eines temperatursensitiven Elementes eines Temperatursensors in einem optischen Element,
- Figur 5: eine schematische Schnittdarstellung eines temperatursensitiven Elementes eines Temperatursensors in einem optischen Element mit einem alternativen Aufbau,
- Figur 6: eine schematisch vergrößerte Schnittdarstellung von im Trägersubstrat angeordneten temperatursensitiven Elementen,
- Figur 7: eine schematische Darstellung eines Pixels eines Temperatursensors, der eine Matrix aus temperatursensitiven Elementen umfasst und
- Figur 8: eine schematische Darstellung eines Pixels eines Temperatursensors mit zwei Matrizen an temperatursensitiven Elementen.

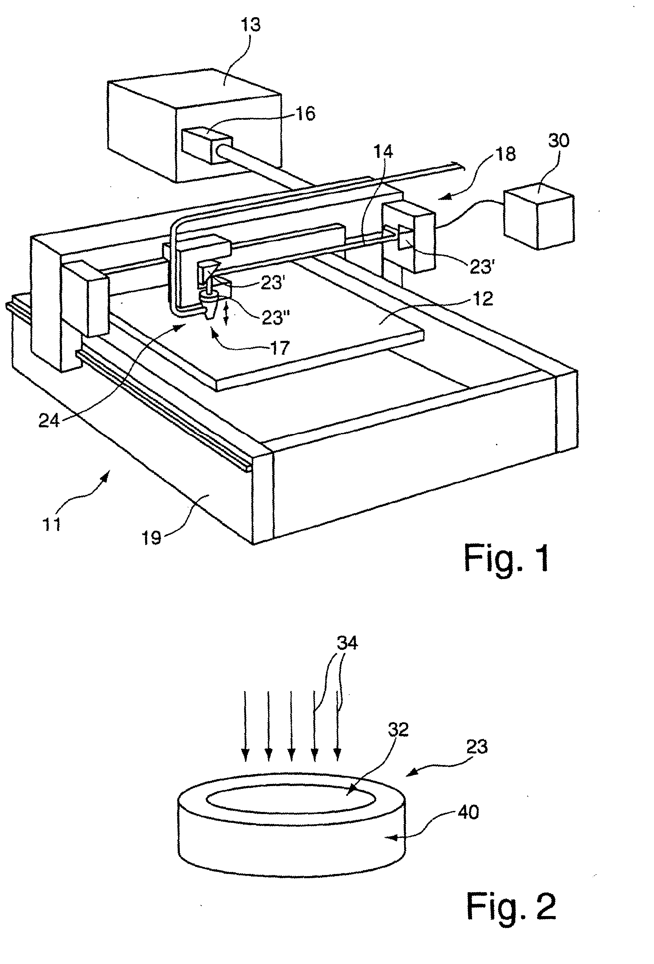

In Figur 1 ist beispielsweise eine Laseranlage 11 dargestellt, die für die Bearbeitung von Materialien und Werkstücken 12 eingesetzt wird. Die Laseranlage 11 umfasst eine Laseranordnung mit einem Lasergerät 13, insbesondere einem CO₂-Laser, das eine elektromagnetische Strahlung, insbesondere einen Laserstrahl 14, erzeugt. Die Wellenlänge des Laserstrahls 14 liegt vorzugsweise im fernen Infrarotbereich. An dem Lasergerät 13 ist ein Strahlteleskop 16 vorgesehen, über das der in dem Lasergerät 13 erzeugte Laserstrahl 14 ausgekoppelt wird. Vom Strahlteleskop 16 bis zur Bearbeitungsstelle 17 wird der Laserstrahl 14 durch eine externe Optik 18 geführt. Die externe Optik 18 ist an einem Maschinengrundgestell 19 vorgesehen, das in Abhängigkeit der Einsatzfälle ein-oder mehrachsig ausgebildet ist. Im vorliegenden Ausführungsbeispiel wird die externe Optik 18 in einer X-, Y- und Z-Richtung bewegt. Eine ein- oder mehrachsige Optik wird auch als fliegende Optik bezeichnet. Alternativ kann auch das Werkstück 12 und/oder die Optik 18 bewegt werden.

Die Laseranlage 11 weist eine Vielzahl von optischen Elementen 23 gemäß Figur 2 auf. Die in dem Lasergerät 13 erforderlichen optischen Elemente 23 werden auch als interne optische Elemente bezeichnet und umfassen beispielsweise Rückspiegel, Auskoppelspiegel, Umlenkspiegel und teiltransmittierende Spiegel als auch teiltransmittierende Optiken, wie Linsen, die nicht näher dargestellt sind. Die externe Optik weist zur Strahlführung und Strahlformung zumindest einen ersten Umlenkspiegel 23' und im Bearbeitungskopf 24 zumindest einen weiteren Umlenkspiegel 23' und eine Fokussieroptik 23'' auf, die beispielsweise als Linse ausgebildet ist. Anstelle des weiteren Umlenkspiegels 23' und der Fokussieroptik 23'' kann auch ein Hohlspiegel vorgesehen sein. Der Strahlweg des Laserstrahls 14 vom Strahlteleskop 16 bis zur Fokussieroptik 23'' ist durch einen Faltenbalg geschlossen.

Das optische Element 23 gemäß Figur 2 umfasst ein Trägersubstrat 40 aus Halbleitermaterial hier Silizium. Auf dem Trägersubstrat 40 ist eine Beschichtung 32 vorgesehen. Diese Beschichtung 32 kann unterschiedliche Metalle oder Metalllegierungen als auch Halbleitermaterialien umfassen. Die Schar von Pfeilen 34 ist stellvertretend für den Laserstrahl 14.

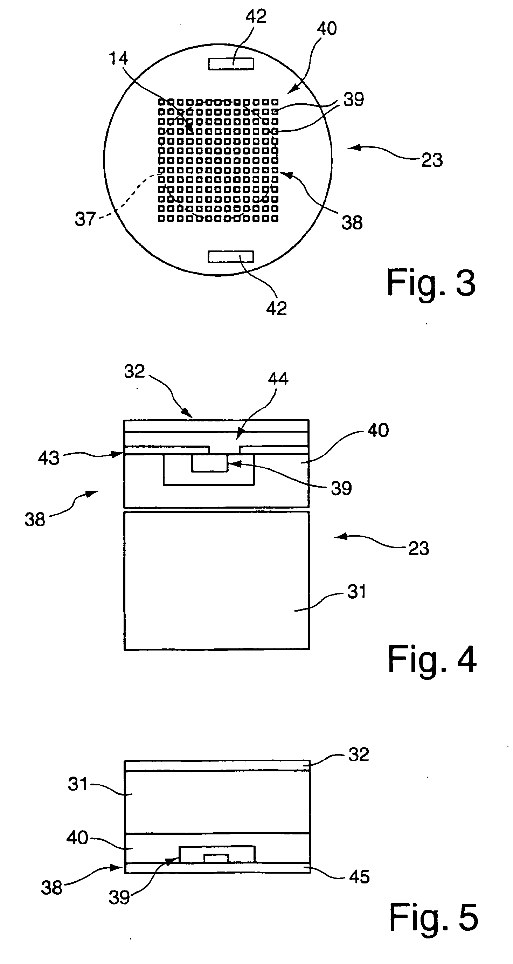

In Figur 3 ist in der Draufsicht ein optisches Element 23 gemäß Figur 2 ohne Beschichtung 32 dargestellt. In dem Trägersubstrat 40 ist ein Temperatursensor 38 vorgesehen oder eingebettet. Dieser Temperatursensor 38 besteht aus einer Vielzahl von in einer Matrix angeordneten Pixel 36, die jeweils zumindest ein temperatursensitives Element 39 umfassen. Beispielsweise ist eine Anordnung vorgesehen, bei der mehrere temperatursensitive Elemente 39 in mehreren Zeilen und Spalten nebeneinander in vorbestimmten Abständen zueinander angeordnet sind.

Die temperatursensitiven Elemente 39 können in Form von Dioden ausgebildet sein, die in einer Matrix, zum Beispiel in Zeilen und Spalten miteinander verbunden sind, um ein empfangenes Signal über symbolisch dargestellte Anschlüsse 42 an eine Auswerteeinheit 30 in einer Laseranlage 11 auszugeben. Solche Anschlüsse 42 können beispielsweise durch Aufdampfen, als Matrizen, durch Beschichten oder Implantierung von Anschlussstücken ausgebildet sein. Des Weiteren können Drähte oder andere Verbindungsstücke eingesetzt werden. Der Temperatursensor 38 kann zusätzlich elektronische Schaltungen umfassen, wie zum Beispiel Multiplexer oder Verstärker, die die Signalaufnahme ermöglichen, vereinfachen oder verbessern. Diese Elemente sind bevorzugt in dem Trägersubstrat 40 eingebettet. Der in Figur 2 dargestellte Kreis 37 symbolisiert den auftreffenden Laserstrahl 14.

Figur 4 zeigt eine schematische Schnittdarstellung einer ersten erfindungsgemäßen Ausführungsform eines Aufbaus eines optischen Elementes 23 mit einem in dem Trägersubstrat 40 integrierten temperatursensitiven Element 39, das Teil eines Temperatursensors 38 ist. Dieses temperatursensitive Element 39 ist beispielsweise als Diode ausgebildet und durch einen CMOS-kompatiblen Prozess in einer aus Silizium bestehenden Schicht oder in einen Siliziumwafer eingebracht. Dieses temperatursensitive Element 39 ist über Verbindungsleitungen 43 mit weiteren temperatursensitiven Elementen 39 in einer Matrix in Form von Zeilen und Spalten verbunden. Auf den temperatursensitiven Elementen 39 wird bevorzugt eine Passivierungsschicht 44 aufgebracht, um ein Übersprechen zu reduzieren beziehungsweise zu verhindern. Auf diese Passivierungsschicht 44 ist die Beschichtung 32 aufgebracht.

Bei dieser Ausführungsform ist der Siliziumwafer bzw. das Trägersubstrat 40 sehr dünn ausgebildet und auf einer Schicht eines Trägermaterials 31 aufgebracht. Es können Trägermaterialien 31 aus Metall, wie beispielsweise Kupfer als auch Silizium, zur Aufnahme des Trägersubstrats 40 vorgesehen sein. Diese Ausgestaltung weist den Vorteil auf, dass verschiedene Trägermaterialien für unterschiedliche Einsatzfälle ausgewählt und mit dem Trägersubstrat 40 kombiniert werden können, um beispielsweise eine für den Anwendungsfall angepasste thermische Leitfähigkeit oder mechanische Festigkeit auszuwählen.

Eine alternative Ausführungsform zu Figur 3 sieht vor, dass das Trägersubstrat aus einer dickeren Schicht aus Silizium besteht, so dass die zusätzliche Verwendung von einem Trägermaterial nicht erforderlich wird.

In Figur 5 ist eine alternative Ausführungsform eines optischen Elementes 23 dargestellt. Diese Ausführungsform weist einen Aufbau auf, bei dem eine Beschichtung 32 auf dem Trägermaterial 31 aufgebracht ist. Auf der der Beschichtung 32 gegenüberliegenden Seite des Trägermaterials 31 ist das Trägersubstrat 40 aufgebracht, wobei der Temperatursensor 38 zur Rückseite des optischen Elementes 23 weist. Der Temperatursensor 38 ist durch eine Absorptionsschicht 45 abgedeckt. Bei dieser Ausführungsform ist das Trägermaterial 31 stark oder volltransmittierend ausgebildet. Bspw. können Materialien wie ZnSe eingesetzt werden. Diese weisen einen Transmissionsgrad von wenigstens 97 % auf. Die Beschichtung 32 ist gemäß der Erfindung mit einer Durchlässigkeit von weniger als 2 % vorgesehen.

Die Beschichtung 32 auf dem Trägersubstrat 40 oder dem Trägermaterial 31 deckt vollflächig den Temperatursensor 39 ab und kann sich vollflächig über die gesamte Oberfläche des Trägersubstrates 40 und dem Trägermaterial 31 mit Ausnahme der Anschlüsse 42 zur Anbringung von Kontaktelementen erstrecken. Die Beschichtung 32 weist eine Doppelfunktion auf, um das Führen und/oder Formen des Laserstrahls zu ermöglichen sowie eine Abschwächung des Laserstrahls für die temperatursensitiven Elemente 39 zu dessen Schutz und zur Messwerterfassung sicherstellen.

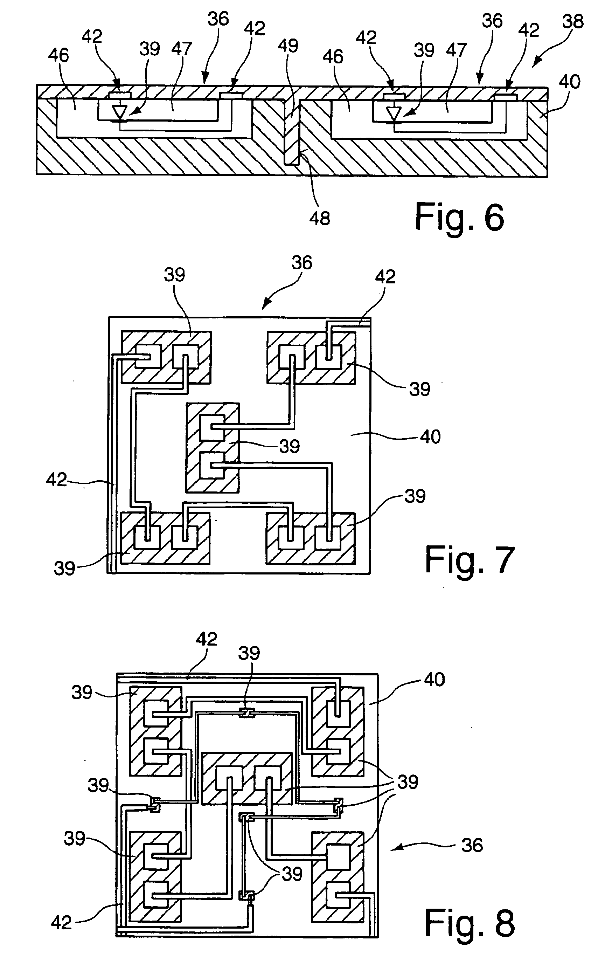

In Figur 6 ist eine schematische vergrößerte Schnittdarstellung von zwei nebeneinander angeordneten Pixel 36 des Temperatursensors 38 im optischen Elementes 23 gemäß Figur 3 dargestellt. Jedes Pixel 36 umfasst eine Diode als temperatursensitives Element 39 in einer p- oder n-dotierte Wanne 46 mit umgekehrt dotierter Diffusionsschicht 47 im Siliziumwafer. Hierzu kann vorteilhafterweise ein CMOS-Prozess verwendet werden. Die p- oder n-dotierten Wannen 46 bewirken eine elektrische Isolierung zwischen den beiden benachbarten temperatursensitiven Elementen 39 und ermöglichen eine Verringerung des Übersprechverhaltens zwischen den temperatursensitiven Elementen 39. In das optische Element 23 können zusätzlich noch Strukturen, wie beispielsweise Gräben 48, eingebracht werden, die die thermische Isolierung zwischen den zur Bildung eines Temperatursensors 38 in einer Matrix angeordneten temperatursensitiven Elementen 39 erhöhen. Diese Gräben 48 werden mit einer thermisch isolierenden Schicht 49 geschlossen. Hierfür werden Trennschnitte oder Ätzungen in die Oberfläche des Wafers eingebracht, die anschließend mit einem isolierenden Material aufgefüllt werden. Dadurch ist das thermische Übersprechen erheblich reduziert.

Zur Erhöhung der Planarität von Siliziumwafern kann vorteilhafterweise auf der Rückseite des Siliziumwafers eine spannungskompensierende Schicht aufgebracht werden. Diese kann beispielsweise aus SiRN (silicon-rich nitride) oder aus Siliziumnitrid oder ähnlichen Materialien vorgesehen sein, die durch ein plasmaunterstütztes Aufdampfverfahren (PECVD) oder ein Niederdruckaufdampfverfahren (LPCVD) aufgetragen wird.

Zur Verringerung der Oberflächenrauhigkeit des Siliziumwafers und somit zur Erhöhung der Spiegeleigenschaften wird die Oberfläche des Trägersubstrats 40 in dem der Temperatursensor 38 vorgesehen oder eingebettet ist, poliert. Zusätzlich können reflektierende Schichten, beispielsweise Goldschichten und/oder dielektrische Schichten, aufgebracht werden.

In Figur 7 ist ein Pixel 36 eines Temperatursensors 38 vergrößert dargestellt. In diesem Ausführungsbeispiel sind beispielhaft fünf temperatursensitive Elemente 39 in Serie miteinander verbunden und bilden das Pixel 36. Diese Anordnung weist den Vorteil auf, dass mehrere temperaturabhängige Merkmale oder Kennlinien erfasst werden können, wodurch die Messgenauigkeit eines jeden Pixels 36 erhöht ist. Alternativ kann vorgesehen sein, dass die temperatursensitiven Elemente 39 in einer Parallelschaltung zueinander angeordnet sind.

Eine alternative Ausgestaltung eines Pixels 36 für einen Temperatursensor 38 ist in Figur 8 dargestellt. Bei diesem Ausführungsbeispiel sind zwei Reihen von temperatursensitiven Elementen 39 in einem Pixel 36 vorgesehen. Diese können wieder gemäß dem Ausführungsbeispiel in Reihe oder auch parallel zueinander geschalten sein. Dadurch kann eine Mehrzahl von Signalen erfasst werden, wobei für ein Ereignis eine qualitativ höherwertige Aussage über den durchschnittlich erfassten Wert ermöglicht ist.

Die optischen Elemente 23 sind in Fassungen oder Aufnahmen der Laseranlage 11 angeordnet. Diese Aufnahmen oder Halteelemente können Kontaktelemente aufweisen, welche beim Einsetzen der optischen Elemente 23 in die Haltevorrichtungen an den Anschlüssen 42 angreifen, so dass eine Kontaktierung erfolgt. Alternativ kann vorgesehen sein, dass andere Kontakte vor dem Einsetzen an den optischen Elementen 23 angebondet oder aufgeklebt werden oder als Steckeranschlüsse ausgebildet sind, um die erfassten Messwerte aus dem optischen Element 23 auszulesen und an die Auswerteeinheit weiterzuleiten. Des Weiteren kann vorgesehen sein, dass anstelle von mechanischen Anschlüssen eine kontaktlose Übertragung der Messdaten von dem optischen Element 23 zur Haltevorrichtung, zur Steuerung oder an weitere Komponenten der Laseranlage 11 ermöglicht ist. In dem optischen Element 23 ist ein Transponder, also ein IC-Speicherelement und eine Antenne, vorgesehen, welche mittels der RFID-Technologie ein kontaktloses Übertragen der Messdaten ermöglicht. Ein solcher Transponder kann in oder auf dem Trägersubstrat 40, dem Trägermaterial 31 oder der Beschichtung 32 vorgesehen sein.

Die vorgenannten Ausführungsbeispiele, die Dioden als temperatursensitive Elemente 39 umfassen, können unterschiedliche Charakteristiken aufweisen, um die Temperatur des Laserstrahls 14 zu erfassen. Solche Charakteristiken können beispielsweise einen vor- oder rückwärtigen Spannungsabfall bei einem bekannten oder konstanten Strom oder einen vor- oder rückwärtigen Strom bei einer bekannten oder konstanten Spannung, die an die temperatursensitiven Elemente 39 angelegt ist, aufweisen.

Durch diese Charakteristiken können die Temperaturabhängigkeiten erfasst werden. Daraus lässt sich ableiten, dass die Spannungsdifferenz unmittelbar proportional zur Temperatur des Pixels ist. Somit lassen sich in Abhängigkeit des auf das optische Element 23 einwirkenden Lasers 14 unmittelbare Rückschlüsse auf die Strahlparameter ziehen.

Durch den in dem Trägersubstrat 40 integrierten oder eingebetteten Temperatursensor 38 sowie dessen Ausgestaltung von zeilen- und spaltenförmig angeordneten Temperaturelementen 39 ist ermöglicht, dass mehrere Parameter gleichzeitig erfasst und ausgewertet werden können. Hierzu gehört beispielsweise die Strahlleistung. Durch die proportionale Änderung der Spannung in Abhängigkeit der Temperaturverteilung kann die Strahlleistung beziehungsweise deren Änderungen erfasst werden. Dabei ist bekannt, welche Ausgangsleistung ein von dem Lasergerät 13 erzeugter Laserstrahl 14 aufweist. Somit kann beispielsweise entlang eines Strahlweges eine Veränderung der Strahlleistung durch einen Vergleich der erfassten Daten an mehreren Messorten erfasst werden. Des Weiteren kann durch die Vielzahl der temperatursensitiven Elemente 39 die Strahllage und deren Abweichung erfasst werden. Somit können Rückschlüsse auf De- oder Fehljustierungen oder Veränderungen in der Lage der optischen Elemente 23 im Strahlengang erfasst werden. Des Weiteren können Strahlprofile ermittelt werden. Aufgrund der direkten Abhängigkeit der Spannung von der Temperatur können durch die Pixelauflösung Strahlprofile erfasst werden.

Die Fern- oder Telediagnose kann des Weiteren dahingehend modifiziert sein, dass entfernt zur Laseranlage 11 ein Vergleich der Ist- und Sollwerte der Parameter, wie beispielsweise Strahllage, Leistung, Strahlprofil, erfolgt und eine Korrektur der Istwerte oder eine Annäherung an Sollwerte von außen erfolgt. Eine solche Fernsteuerung ermöglicht eine Überwachung und Steuerung mehrerer Laseranlagen 11 von einem zentralen Arbeitsplatz aus.

Diese Informationen werden an eine Auswerteeinheit 30 weitergeleitet. Die Auswerteeinheit 30 kann in dem Lasergerät 13 integriert, daran angeordnet oder entfernt dazu in Verbindung mit einer externen Optik 18 stehen. Diese Auswerteeinheit 30 kann über eine Datenleitung, über Funk oder dergleichen die erfassten Daten ausgeben, so dass eine Fern-oder Telediagnose ermöglicht ist. Darüber hinaus weist die jederzeit ermöglichte Abfrage der aktuellen Parameter eines Laserstrahles 14 den Vorteil auf, dass keine Unterbrechung des Arbeitsprozesses erforderlich und eine vollständige Überwachung der Laseranlage 11 im Betrieb ermöglicht ist. Durch die Erfassung der Temperaturverteilung im optischen Element 23 kann mittels der Deconvolutions-Methode ein Strahlprofil ermittelt werden. Des Weiteren kann durch Anwendung der Maximal-Entropie-Methode das Strahlprofil aus der Temperaturverteilung ermittelt werden.

Durch den Vergleich der erfassten Werte mit der Gesamtleistung kann darüber hinaus eine beginnende Verschmutzung, Alterung oder Beschädigung der optischen Elemente 23 erkannt werden. Gleichzeitig kann durch diese Erfassung der Daten auf einen sogenannten Mode-Schuhs verzichtet werden. Durch den im optischen Element 23 integrierten Temperatursensor 38 können die erforderlichen Daten ermittelt werden. Somit ist eine zeitaufwändige Stillsetzung der Laseranlage 11 sowie ein aufwändiges Auskoppeln eines Laserstrahles 14 nicht erforderlich. Zudem kann eine Ferndiagnose, Fernwartung und Fernsteuerung von Laseranlagen ermöglicht werden.

## Patentansprüche

1. Optisches Element zum Führen und Formen eines Laserstrahles (14), welches insbesondere in einer Laseranlage (11) anordenbar ist, mit einem Trägersubstrat (40) und einer zumindest einseitig auf dem Trägersubstrat (40) aufgebrachten Beschichtung (32) und mit zumindest einem Temperatursensor (38), **dadurch gekennzeichnet, dass** der Temperatursensor (38) aus mehreren in einer Matrix angeordneten Pixeln (36) besteht und das jeweilige Pixel (36) wenigstens ein temperatursensitives Element (39) umfasst, und dass das zumindest eine temperatursensitive Element (39) des Pixels (36) in einem aus Silizium bestehenden Trägersubstrat (40) aufgebaut ist, und die Beschichtung (32) einen Reflektionsgrad der Strahlung von wenigstens 98 % aufweist.

2. Optisches Element nach Anspruch 1, **dadurch gekennzeichnet, dass** das zumindest eine temperatursensitive Element (39) in einem Siliziumwafer, insbesondere als Diode, aufgebracht ist.

3. Optisches Element nach einem der vorhergehenden Ansprüche, **dadurch gekennzeichnet, dass** die temperatursensitiven Elemente (39) in sogenannten p- oder n-dotierten Vertiefungen oder Wannen (46) vorgesehen sind.

4. Optisches Element nach einem der vorhergehenden Ansprüche, **dadurch gekennzeichnet, dass** die temperatursensitiven Elemente (39) durch Isolierabschnitte (48,49) thermisch zueinander isoliert sind.

5. Optisches Element nach einem der vorhergehenden Ansprüche, **dadurch gekennzeichnet, dass** mehrere temperatursensitive Elemente (39) in einem Pixel (36) in Reihe geschalten sind.

6. Optisches Element nach einem der Ansprüche 1 bis 4, **dadurch gekennzeichnet, dass** mehrere temperatursensitive Elemente (39) in einem Pixel (36) parallel geschalten sind.

7. Optisches Element nach einem der vorhergehenden Ansprüche, **dadurch gekennzeichnet, dass** an einer dem Temperatursensor (38) zugewandten Seite des Trägersubstrats (40) die Beschichtung (32) und auf einer dem Temperatursensor (38) abgewandten Seite des Trägersubstrats (40) ein Trägermaterial (31) vorgesehen ist.

8. Optisches Element nach einem der Ansprüche 1 bis 6, **dadurch gekennzeichnet, dass** an einer dem Temperatursensor (38) abgewandten Seite des Trägersubstrates (40) ein Trägermaterial (31) vorgesehen und auf einer gegenüberliegenden Seite des Trägermaterials (31) die Beschichtung (32) vorgesehen ist.

9. Optisches Element nach Anspruch 8, **dadurch gekennzeichnet, dass** das Trägermaterial (31) hochtransmittiv ausgebildet ist.

10. Optisches Element nach einem der vorhergehenden Ansprüche, **dadurch gekennzeichnet, dass** zwischen dem die temperatursensitiven Elemente (39) aufnehmenden Trägersubstrat (40) und der an dem Trägersubstrat vorgesehenen Beschichtung (32) eine Passivierungsschicht (44) vorgesehen ist oder dass an dem die temperatursensitiven Elemente (39) aufnehmenden Trägersubstrat (40) eine Absorberschicht (45) vorgesehen ist.

11. Optisches Element nach einem der vorhergehenden Ansprüche, **dadurch gekennzeichnet, dass** auf einer der Beschichtung (32) abgewandten Seite des Trägermaterials (31) oder des Trägersubstrats (40) eine spannungskompensierende Schicht aufgebracht ist.

12. Optisches Element nach einem der vorhergehenden Ansprüche, **dadurch gekennzeichnet, dass** zumindest ein Multiplexer und vorzugsweise elektronische Bauelemente benachbart zur aus Pixeln (36) bestehenden Matrix in dem Trägersubstrat (40) aufgebaut sind.

13. Verfahren zur Erfassung und Überwachung von Strahlparametern eines Laserstrahles (14) in einer Laseranlage (11) mit einem oder mehreren optischen Elementen gemäß einer der Ansprüche 1 bis 12, **dadurch gekennzeichnet, dass** die von dem oder den optischen Elementen (23) erfassten Daten an eine Auswerteeinheit (30) der Laseranlage (11) weitergeleitet werden, wobei die Daten der einzelnen Pixel (36) erfasst und durch einen Ist- /Sollwertvergleich ausgewertet werden.

14. Verfahren nach Anspruch 13, **dadurch gekennzeichnet, dass** die erfassten Daten von der Auswerteeinheit (30) zur Datenfernübertragung an eine zentrale Erfassungsstelle ausgegeben werden.

15. Verfahren nach Anspruch 14, **dadurch gekennzeichnet, dass** Strahlparameter der Laseranlage (11) von der Erfassungsstelle, die räumlich getrennt zur Laseranlage (11) vorgesehen ist, eingestellt und überwacht werden.

## Claims

1. An optical element for guiding and shaping a laser beam (14), which is arranged in particular in a laser system (11), comprising a carrier substrate (40) and a coating (32), which is applied to at least one side of the carrier substrate (40) and comprising at least one temperature sensor (38), **characterized in that** the temperature sensor (38) comprises a plurality of pixels (36) arranged in a matrix and the respective pixel (36) comprises at least one temperature-sensitive element (39), and **in that** the at least one temperature-sensitive element (39) of the pixel (36) is constructed in a carrier substrate (40) comprising silicon and **in that** the coating (32) has a reflectance of the radiation of at least 98%.

2. The optical element as claimed in claim 1, **characterized in that** the at least one temperature-sensitive element (39) is applied in a silicon wafer, in particular as a diode.

3. The optical element as claimed in one of the preceding claims, **characterized in that** the temperature-sensitive elements (39) are provided in so-called p- or n-doped depressions or wells (46).

4. The optical element as claimed in one of the preceding claims, **characterized in that** the temperature-sensitive elements (39) are thermally insulated from one another by insulating sections (48, 49).

5. The optical element as claimed in one of the preceding claims, **characterized in that** a plurality of temperature-sensitive elements (39) are connected in series in a pixel (36).

6. The optical element as claimed in one of claims 1 to 4, **characterized in that** a plurality of temperature-sensitive elements (39) are connected in parallel in a pixel (36).

7. The optical element as claimed in one of the preceding claims, **characterized in that** the coating (32) is provided at a side of the carrier substrate (40) which faces the temperature sensor (38), and a carrier material (31) is provided on a side of the carrier substrate (40) which is remote from the temperature sensor (38).

8. The optical element as claimed in one of claims 1 to 6, **characterized in that** a carrier material (31) is provided at a side of the carrier substrate (40) which is remote from the temperature sensor (38), and the coating (32) is provided on an opposite side of the carrier material (31).

9. The optical element as claimed in claim 8, **characterized in that** the carrier material (31) is formed in highly transmissive fashion.

10. The optical element as claimed in one of the preceding claims, **characterized in that** a passivation layer (44) is provided between the carrier substrate (40) receiving the temperature-sensitive elements (39) and the coating (32) provided at the carrier substrate, or **in that** an absorber layer (45) is provided at the carrier substrate (40) receiving the temperature-sensitive elements (39).

11. The optical element as claimed in one of the preceding claims, **characterized in that** a stress-compensating layer is applied on a side of the carrier material (31) or of the carrier substrate (40) which is remote from the coating (32).

12. The optical element as claimed in one of the preceding claims, **characterized in that** at least one multiplexer and preferably electronic components are constructed adjacent to the matrix comprising pixels (36) in the carrier substrate (40).

13. A method for recording and monitoring beam parameters of a laser beam (14) in a laser system (11) with one or a plurality of optical elements as claimed in one of claims 1 to 12, **characterized in that** the data recorded by the optical element or optical elements (23) are forwarded to an evaluation unit (30) of the laser system (11), the data of the individual pixels (36) being recorded and evaluated by an actual/desired value comparison.

14. The method as claimed in claim 13, **characterized in that** the recorded data are output by the evaluation unit (30) for remote data transmission to a central recording location.

15. The method as claimed in claim 14, **characterized in that** beam parameters of the laser system (11) are set and monitored by the recording location, which is provided in a manner spatially separated from the laser system (11).

## Revendications

1. Elément optique qui guide et façonne un faisceau laser (14) et qui est installé en particulier dans une installation laser (11), qui présente un substrat porteur (40) et un revêtement (32) appliqué sur au moins une face du substrat porteur (40) ainsi qu'au moins une sonde de température (38),
**caractérisé en ce que**
la sonde de température (38) est constituée de plusieurs pixels (36) disposés en matrice et **en ce que** chaque pixel (36) comprend au moins un élément (39) sensible à la température, **en ce que** le ou les éléments (39) sensibles à la température du pixel (36) sont incorporés dans un substrat porteur (40) constitué de silicium et **en ce que** le revêtement (32) présente un taux de réflexion du rayonnement d'au moins 98 %.

2. Elément optique selon la revendication 1, **caractérisé en ce que** le ou les éléments (39) sensibles à la température sont installés dans une galette de silicium et ont en particulier la forme de diodes.

3. Elément optique selon l'une des revendications précédentes, **caractérisé en ce que** les éléments (39) sensibles à la température sont prévus dans des creux ou cuvettes (46) dopés positivement ou négativement.

4. Elément optique selon l'une des revendications précédentes, **caractérisé en ce que l**es éléments (39) sensibles à la température sont isolés thermiquement les uns des autres par des parties isolantes (48, 49).

5. Elément optique selon l'une des revendications précédentes, **caractérisé en ce que** plusieurs éléments (39) sensibles à la température sont raccordés en série dans un pixel (36).

6. Elément optique selon l'une des revendications 1 à 4, **caractérisé en ce que** plusieurs éléments (39) sensibles à la température sont raccordés en parallèle dans un pixel (36).

7. Elément optique selon l'une des revendications précédentes, **caractérisé en ce que** le revêtement (32) est prévu sur la face du substrat porteur (40) tournée vers la sonde de température (38) et **en ce qu'**un matériau de support (31) est prévu sur la face du substrat porteur (40) qui n'est pas tournée vers la sonde de température (38).

8. Elément optique selon l'une des revendications 1 à 6, **caractérisé en ce qu'**un matériau de support (31) est prévu sur la face du substrat porteur (40) non tournée vers la sonde de température (38) et **en ce que** le revêtement (32) est prévu sur la face opposée du matériau de support (31).

9. Elément optique selon la revendication 8, **caractérisé en ce que** le matériau de support (31) une transmissivité élevée.

10. Elément optique selon l'une des revendications précédentes, **caractérisé en ce qu'**une couche de passivation (44) est prévue entre le substrat porteur (40) qui loge les éléments (39) sensibles à la température et le revêtement (32) prévu sur le substrat porteur ou **en ce qu'**une couche d'absorption (45) est prévue sur le substrat porteur (40) qui loge les éléments (39) sensibles à la température.

11. Elément optique selon l'une des revendications précédentes, **caractérisé en ce qu'**une couche de compensation de tension est appliquée sur la face du matériau de support (31) ou du substrat porteur (40) qui n'est pas tournée vers le revêtement (32).

12. Elément optique selon l'une des revendications précédentes, **caractérisé en ce qu'**au moins un multiplexeur et de préférence des composants électroniques sont montés dans le substrat porteur (40) au voisinage de la matrice composée de pixels (36).

13. Procédé de détection et de surveillance de paramètres d'un faisceau laser (14) d'une installation laser (11) qui présente un ou plusieurs éléments optiques selon les revendications 1 à 12,
**caractérisé en ce que**
les données saisies par le ou les éléments optiques (23) sont transmises à une unité d'évaluation (30) de l'installation laser (11), les données des différents pixels (36) étant saisies et évaluées en comparant leur valeur effective à leur valeur de consigne.

14. Procédé selon la revendication 13, **caractérisé en ce que** les données saisies sont transmises par l'unité d'évaluation (30) à un emplacement centralisé de détection par transmission de données à distance.

15. Procédé selon la revendication 14, **caractérisé en ce que** les paramètres du faisceau de l'installation laser (11) sont réglés et surveillés par l'emplacement de détection disposé à distance de l'installation laser (11).
